# EUROPÄISCHE PATENTSCHRIFT

(11) **EP 1 039 548 B1**
(45) Veröffentlichungstag und Bekanntmachung des Hinweises auf die Patenterteilung: **31.03.2004**
(21) Anmeldenummer: 00112818.0
(22) Anmeldetag: 30.01.1997
(51) Int. Cl.: H01L 29/78, H01L 29/739, H01L 21/336, H01L 21/331, H01L 29/06

(54) **Durch Feldeffekt steuerbares Halbleiterbauelement**
Field effect controlled semiconductor component
Composant semi-conducteur commandé par effet de champ

(30) Priorität: 05.02.1996 DE 19604043; 05.02.1996 DE 19604044
(43) Veröffentlichungstag der Anmeldung: 27.09.2000
(62) Teilanmeldung aus: 97907035.6
(73) Patentinhaber: Infineon Technologies AG, 81669 München (DE)
(72) Erfinder: Tihanyi, Jenö, 85551 Kirchheim (DE); Strack, Helmut, 80804 München (DE); Geiger, Heinrich, 83607 Holzkirchen (DE)
(74) Vertreter: Bickel, Michael

(56) Entgegenhaltungen:
- EP-A- 0 114 435
- EP-A- 0 634 798
- CN-A- 1 115 909
- US-A- 4 754 310
- US-A- 5 155 574
- US-A- 5 216 275
- US-A- 5 313 082
- US-A- 5 438 215
- PATENT ABSTRACTS OF JAPAN vol. 016, no. 347 (E-1240), 27. Juli 1992 (1992-07-27) -& JP 04 107867 A (MATSUSHITA ELECTRON CORP), 9. April 1992 (1992-04-09)

## Beschreibung

Die Erfindung betrifft ein durch Feldeffekt steuerbares Halbleiterbauelement bestehend aus einem Halbleiterkörper,
a) mit einer inneren Zone vom ersten Leitungstyp, die an eine der Oberflächen des Halbleiterkörpers angrenzt,
b) mit einer Drainzone, die an die Innenzone angrenzt,
c) mit mindestens einer Basiszone vom zweiten Leitungstyp, die in die besagte Oberfläche des Halbleiterkörpers eingebettet ist,
d) mit mindestens einer Sourcezone vom ersten Leitungstyp, welche in die Basiszone eingebettet ist,
e) mit mindestens einer Sourceelektrode, die jeweils eine Basiszone und die darin eingebetteten Sourcezonen kontaktiert und
f) mit einer gegen den gesamten Halbleiterkörper isolierten Gatelektrode.

Derartige vertikale durch Feldeffekt steuerbare Halbleiterbauelemente sind seit langem Stand der Technik. Zum einen sind sie als VMOS-Feldeffekttransistoren bekannt, sofern die Drainzone, die an die Innenzone angrenzt, vom selben Leitungstyp wie die Innenzone ist. Zum anderen sind solche durch Feldeffekt steuerbare Halbleiterbauelemente als IGBTs bekannt, sofern die Drainzone als Anodenzone ausgebildet ist und vom entgegengesetzten Leitungstyp ist wie die Innenzone.

Ferner betrifft die Erfindung auch durch Feldeffekt steuerbare Halbleiterbauelemente bestehend aus einem Halbleiterkörper vom ersten Leitungstyp,
a) mit einer Sourcezone und einer Drainzone vom zweiten Leitungstyp, die räumlich voneinander getrennt sind und jeweils mit einer Sourceelektrode und einer Drainelektrode versehen sind,
b) mit einer zwischen der Sourcezone und der Drainzone liegenden und an die Drainzone angrenzenden Driftzone vom zweiten Leitungstyp, und
c) mit einer gegen die Oberfläche des Halbleiterkörpers isolierten Gateelektrode, die die Sourcezone und die Driftzone teilweise überdeckt.

Solche lateralen durch Feldeffekt steuerbare Halbleiterbauelemente sind seit langer Zeit als laterale MOSFETs bekannt.

Die eingangs genannten Halbleiterbauelemente sind ausführlich in dem Buch Jens Peer Stengl; Jenö Tihanyi: Leistungs-MOS-FET-Praxis, 2. Auflage, Pflaumverlag, München, 1992 erörtert.

Allen eingangs genannten Halbleiterbauelementen ist der Nachteil inhärent, daß der Durchlaßwiderstand Rₒₙ der Drain-Source-Laststrecke mit zunehmender Spannungsfestigkeit des Halbleiterbauelements zunimmt, da die Dicke der Innenzone bzw. der Driftzone zunehmen muß. Bei VMOS-MOSFETs liegt bei einer Spannung von 50 V der flächenbezogene Durchlaßwiderstand Rₒₙ bei ungefähr 0,20 Ohm/m² und steigt bei einer Sperrspannung von 1000 V beispielsweise auf einen Wert von ca. 10 Ohm/m² an.

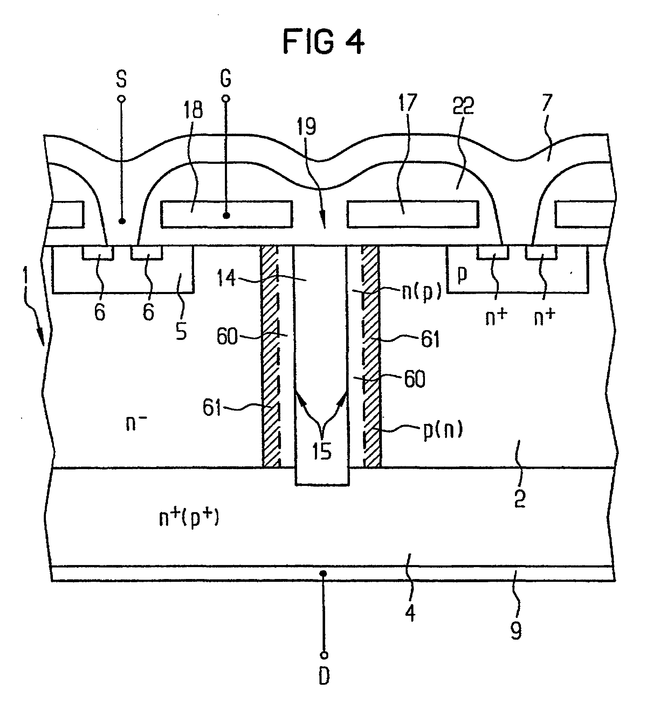

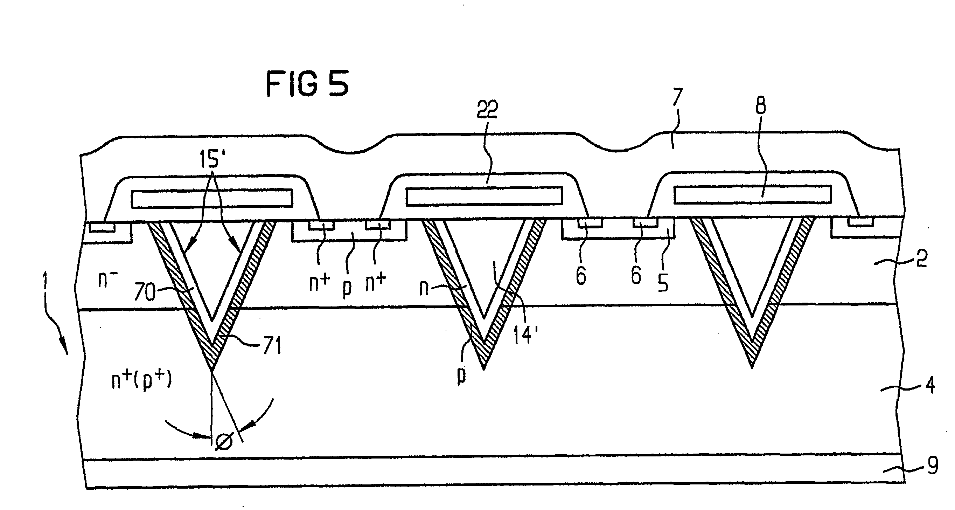

Um diesen Nachteil zu beseitigen, wird in der US 5,216,275 ein vertikaler MOSFET vorgestellt, bei dem statt einer homogenen beispielsweise epitaktisch aufgewachsenen Innenzone alternierend Schichten vom ersten und vom zweiten Leitungstyp vorliegen. Der prinzipielle Aufbau ist dort insbesondere in den Figuren 4 und 5 sowie den dazu gehörigen Teilen der Beschreibung aufgezeigt. Insbesondere werden dort die abwechselnden p- und n-Schichten jeweils mit den Basiszonen und den Drainzonen verbunden. Dies führt jedoch zu einer starken Einschränkung im Design eines Halbleiterbauelements, da die Randbereiche nicht mehr frei gestaltet werden können.

Die US 5,438,215 beschreibt einen Leistungs-MOSFET, in dessen Driftzone benachbart zueinander Halbleiterzonen des selben Leitungstyps wie die Driftzone und Halbleiterzonen des komplementären Leitungstyps wie die Driftzone angeordnet sind, die sich bei Anlegen einer Sperrspannung an das Bauelement gegenseitig ausräumen. Die komplementär zu der Driftzone dotierten Halbleiterzonen sind dabei an das Source-Potential des Bauelements angeschlossen.

Grundlegende Aspekte solcher Kompensationsbauelemente sind beispielsweise in der US 4,754,310 beschrieben.

Die US 5,155,574 beschreibt einen n-Kanal-MOSFET in dessen n-dotierter Driftzone kugelförmige p-dotierte Halbleiterzonen angeordnet sind, die eine ringartige Struktur um eine p-dotierte Body-Zone des Halbleiterbauelements bilden. Aufgabe dieser p-dotierten Body-Zonen ist es, im Sperrfall die Krümmung des Feldlinienverlaufs im Bereich der p-dotierten Body-Zone zu reduzieren, um dadurch die Spannungsfestigkeit des Bauelements zu erhöhen. Diese p-dotierten Zonen bilden eine Schutzstruktur zum Schutz der p-dotierten Body-Zonen vor hohen Feldstärken, bzw. sie beeinflussen die Krümmung des Feldlinienverlaufs im Bereich der p-dotierten Body-Zonen.

Aufgabe der vorliegenden Erfindung ist es, ein mittels Feldeffekt steuerbares Halbleiterbauelement mit erhöhter Spannungsfestigkeit zur Verfügung zu stellen, das mehr Freiheit beim Design des Halbleiterbauelements ermöglicht.

Diese Aufgabe wird durch ein Halbleiterbauelement gemäß Patentanspruch 1 gelöst. Vorteilhafte Ausgestaltungen der Erfindung sind Gegenstand der Unteransprüche.

Die Erfindung weist den Vorteil auf, daß durch einfaches Einbringen von - bei V-MOSFETs und IGBTs vorzugsweise gepaarten Ausräumzonen und Komplementärausräumzonen, insbesondere entlang des Strompfades, zum einen durch die Komplementäraus räumzonen eine gute Leitfähigkeit gewährleistet wird und sich zum anderen bei Erhöhung der Drainspannung diese Bereiche gegenseitig ausräumen, wodurch eine hohe Sperrspannung gesichert bleibt.

Liegt an den so ausgebildeten Halbleiterbauelementen eine Sperrspannung an, so bildet sich ausgehend vom pn-Übergang zwischen der Innenzone und der oder den Basiszonen bei den vertikalen Halbleiterbauelementen eine Raumladungszone aus, deren Ausdehnung mit steigender Sperrspannung wächst. Stößt die Raumladungszone an die Ausräumzonen an, so werden diese über das ausgeräumte Gebiet der Innenzone hochohmig an die Basiszonen angeschlossen. Bei weitersteigender Sperrspannung dehnt sich die Raumladungszone weiter aus, so daß auch ein Teil der Ladungsträger aus den Ausräumzonen und Komplementärausräumzonen ausgeräumt wird. Bei weiterer Steigerung der Sperrspannung sind dann die Ladungsträger aus einem großen Teil der Innenzone und aus den Ausräumzonen und Komplementärausräumzonen vollständig ausgeräumt. Die Raumladungszone wird dadurch in Richtung der Drain- bzw. der Anodenzone verlagert. Bei maximal anliegender Spannung liegen die Ausräumzonen und die Komplementärausräumzonen vollständig in der Raumladungszone. Analog dazu ist die Funktion der Ausräumzonen und Komplementärausräumzonen bei den lateralen MOSFETs.

Da die Gesamtmenge an Dotierung in den Ausräumzonen in etwa der Gesamtmenge an Dotierung in den Komplementärausräumzonen entspricht, wird gewährleistet, daß bei Erhöhung der Drainspannung die derart gebildeten p--n-Bereiche sich gegenseitig vollständig ausräumen, d.h. wie eine einzige Isolatorzone verhalten, wodurch eine hohe Sperrspannung gesichert bleibt.

In einer Ausführungsform der vorliegenden Erfindung sind die Ausräumzone und die Komplementärausräumzone in der Innenzone jeweils paarweise angeordnet. Typischerweise weisen dann die paarweise eingebrachten Ausräumzonen und Komplementärausräumzonen in der Innenzone einen Abstand voneinander größer oder gleich 0 und kleiner oder gleich der Breite der Raumladungszone auf.

In einer alternativen Ausführung der vorliegenden Erfindung ist in die Innenzone eine einzige Komplementärausräumzone eingebracht, in die eine Vielzahl von Ausräumzonen eingebracht sind, wobei dann typischerweise der Abstand der Ausräumzonen innerhalb der Komplementärausräumzone zueinander kleiner gleich der Breite der Raumladungszone zwischen der Ausräumzone und der Komplementärausräumzone ist.

Bei dieser Ausführungsform können die in die Komplementärausräumzone eingebrachten Ausräumzonen in etwa kugelförmige, quaderförmige oder irreguläre Gestalt aufweisen.

Zweckmäßigerweise entspricht in einer Weiterbildung dieser alternativen Ausführungsform der vorliegenden Erfindung die Komplementärausräumzone der gesamten Innenzone.

Schließlich betrifft die Erfindung noch ein Verfahren zum Herstellen von paarweise angeordnetenAusräumzonen/Komplementärausräumzonen. Erfindungsgemäß wird dabei auf ein Substrat eine erste Epitaxieschicht aufgebracht, die p-Dotierstoffe und n-Dotierstoffe in etwa gleichen Mengen enthält, wobei die Diffusionskoeffizienten der beiden Dotierelemente sich deutlich voneinander unterscheiden. In die erste Epitaxieschicht werden danach Gräben geätzt und diese Gräben werden mit einer zweiten hochohmigen Epitaxieschicht aufgefüllt. Das so prozessierte Substrat wird daraufhin einem Temperschritt unterworfen, bei dem die beiden unterschiedlich schnell diffundierenden Dotierelemente der ersten Epitaxieschicht in die zweite Epitaxieschicht eindiffundieren können. Aufgrund des unterschiedlichen Diffusionsverhaltens bilden sich danach paarweise Ausräumzonen und Komplementärausräumzonen an den Grabenrändern aus.

Die Erfindung ist in der Zeichnung beispielsweise veranschaulicht und im folgenden anhand der Zeichnung beschrieben.

Es zeigen :
- Figur 1: einen Teilschnitt durch einen erfindungsgemäßen Vertikal-MOSFET der -in entsprechend mit A, B, C gekennzeichneten Bereichen- verschiedene Realisierungsmöglichkeiten aufzeigt,
- Figur 2: einen Teilschnitt durch einen alternativen erfindungsgemäßen V-MOSFET,
- Figur 3: einen Teilschnitt durch einen weiteren erfindungsgemäßen V-MOSFET mit einer Grabenstruktur,
- Figur 4: einen Teilschnitt durch einen weiteren erfindungsgemäßen V-MOSFET mit Grabenstruktur,
- Figur 5: einen Teilschnitt durch einen erfindungsgemäßen V-MOSFET mit V-förmiger Grabenstruktur,
- Figur 6: einen Teilschnitt durch einen erfindungsgemäßen lateralen MOSFET,
- Figur 7a bis 7d: zeigen jeweils teilweise Schnitte, anhand derer die charakteristischen Verfahrensschritte zur Herstellung eines erfindungsgemäßen vertikalen MOSFET gezeigt werden,
- Figur 8a bis 8b: jeweils teilweise Schnitte anhand derer alternative Verfahrensschritte zur Herstellung eines erfindungsgemäßen vertikalen MOSFET gezeigt werden, und

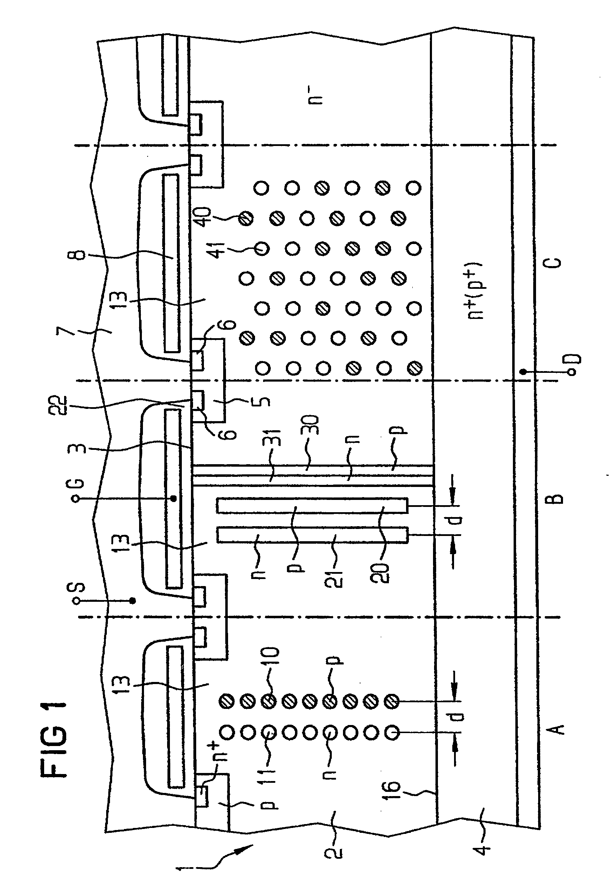

In den Figuren 1 bis 5 ist der Halbleiterkörper des Halbleiterbauelements mit 1 bezeichnet. Er hat eine sourceseitige Oberfläche 3 und eine drainseitige Oberfläche 16. Er weist eine n⁻-dotierte Innenzone 2 auf, die an die Oberfläche 3 des Halbleiterkörpers 1 angrenzt. In die Oberfläche 3 sind mehrere Basiszonen 5 eingebettet. Diese Basiszonen 5 weisen zellenförmige Strukturen auf. Solche Zellenstrukturen können streifenförmig, sechseckig, dreieckig, rund oder viereckig sein. Die Basiszonen 5 haben den der Innenzone 2 entgegengesetzten Leitungstyp, d.h. sie sind im gezeigten Fall p-dotiert. In die Basiszonen 5 sind jeweils'zwei stark n-dotierte Sourcezonen 6 eingebettet. Die Basiszonen 5 und die Sourcezonen 6 sind von Sourceelektroden 7 kontaktiert, die aus Metall, beispielsweise Aluminium bestehen.

An die andere Seite der Innenzone 2 grenzt eine stark n-dotierte Drainzone 4, bzw. im Fall eines IGBTs eine stark p-dotierte Anodenzone an. Diese ist über eine Metallisierung mit einer Drainelektrode 9 versehen.

Die Basiszonen 5 sind über Zwischenzellenzonen 13 räumlich voneinander getrennt.

Isoliert durch eiw Gateoxid über der sourceseitigen Oberfläche 3 ist eine Gateelektrode 8 angeordnet. Die Gateelektrode 8 kann aus hochdotiertem Polysilizium bzw. aus Metall bestehen.

In Figur 1 werden verschiedene Ausführungsformen der vorliegenden Erfindung der Übersichtlichkeit halber in einer einzigen Figur gezeigt.

Figur 1 zeigt in den Zwischenzellenzonen 13 innerhalb der Innenzone 2 verschiedene Ausräumzonen, Komplementärausräumzonen 10, 11 bzw. 20, 21 bzw. 30, 31 bzw. 40, 41 eingebracht. Diese können miteinander in Kontakt stehen, d.h. sie können einander berühren, sie müssen einander jedoch nicht berühren. Sofern sie einander berühren, was bei der gezeigten Komplementärausräumzone 30 und der gezeigten Ausräumzone 31 der Fall ist, bilden sie einen pn-Übergang.

Alle gezeigten Ausräumzonen sind p-dotiert und alle gezeigten Komplementärausräumzonen sind n-dotiert. Die Ausräumzonen und Komplementärausräumzonen können, wie im Bereich A mit den Bezugszeichen 10, 11 dargestellt, kugelförmig ausgebildet sein und sich entlang des Strompfades der Drain-Source-Laststrecke erstrecken. Im Bereich B sind die Komplementärausräumzonen 21, 31 und Ausräumzonen 20, 30 fadenförmig bzw. streifenförmig ausgebildet. Dort sind die Ausräumzonen 20 und Komplementärausräumzonen 21 innerhalb der Innenzone 2 "floatend", d.h. frei schwebend, ausgeführt und füllen nur einen Teil der Innenzone 2 aus. Sie können aber auch -wie durch die Bezugszeichen 30, 31 angedeutet- von der sourceseitigen Oberfläche 3 bis zur drainseitigen Oberfläche 16 und/oder in die Drainzone 4 hineinreichen. Wie im Bereich B gezeigt, kann der Abstand d der Ausräumzonen und Komplementärausräumzonen zueinander größer oder gleich 0 sein.

Im Bereich C ist eine weitere Ausführungsform dargestellt, bei der eine statistische Verteilung der Ausräumzonen und Komplementärausräumzonen 40, 41 vorgesehen ist. Dabei kann die Gestalt der Ausräumzonen und Komplementärausräumzonen 40, 41 sowie auch die Dotierungsverteilung innerhalb der einzelnen Ausräumzonen bzw. Komplementärausräumzonen unregelmäßig sein.

Erfindungswesentlich ist, daß die Gesamtmenge der Dotierung der Ausräumzonen in etwa der Gesamtmenge der Dotierung der Komplementärausräumzonen entspricht. Ferner ist zu beachten, daß die Summe der Volumenausdehnungen der eingebrachten Ausräumzonen ungefähr gleich oder kleiner der der Komplementärausräumzonen ist.

Des weiteren sollte im Fall der Anordnung gemäß dem Bereich C die durchschnittliche Konzentration der verteilten Ausräumzonen in etwa gleich oder größer der der eingebrachten Komplementärausräumzonen sein.

Der Abstand d zwischen den einzelnen Ausräumzonen und Komplementärausräumzonen sollte vorzugsweise kleiner als die Breite der Raumladungszone zwischen den Komplementärausräumzonen und Ausräumzonen bei der Durchbruchsspannung zwischen den benachbarten Ausräumzonen und Komplementärausräumzonen sein. Der Abstand d kann aber wie im Bereich B gezeigt, auch zu 0 werden.

Nachfolgend wird die Funktionsweise der in Figur 1 gezeigten Strukturen näher erläutert.

Bei kleiner Drainspannung ist die Leitfähigkeit gut, da die Komplementärausräumzonen niederohmig sind. Wird die Drainspannung erhöht, werden bei moderater Spannung, z.B. einer Spannung kleiner 30 V, die Ausräumzonen bzw. Komplementärausräumzonen gegenseitig ausgeräumt. Bei einer weiteren Spannungserhöhung wird nun die vertikale Feldstärke weiter erhöht und die Innenzone 2 nimmt die Spannung auf.

Im einzelnen erfolgt dieser Vorgang folgendermaßen:

Die Ausräumung startet von der sourceseitigen Oberfläche 3 unter der Gateelektrode 8 und in den Basiszonen 5 eingebetteten Sourcezonen 6. Sie schreitet dann in die Ausräumzonen bzw. die Komplementärausräumzonen voran. Wenn die Raumladungszone die ersten Ausräumzonen erreicht, bleiben diese Gebiete auf der Spannung, die das Potential der Raumladungszone erreicht hat. Dann wird die nächste Umgebung in Richtung der Drainzone 1 ausgeräumt. Dieser Vorgang wiederholt sich von Schicht zu Schicht. Auf diese Weise schreitet die Raumladungszone voran, bis die Zone unterhalb der eingebrachten Dotierungen innerhalb der Innenzone 2 erreicht wird. Insgesamt wird dann die Raumladungszone so aufgebaut, als ob die zusätzlich eingebrachten Ausräumzonen und Komplementärausräumzonen nicht vorhanden wären.

Die Spannungsfestigkeit wird dabei nur durch die Dicke der Innenzone 2 bestimmt. Somit kann die erfindungsgemäße Anordnung beide Erfordernisse erfüllen, nämlich einen niederohmigen Durchlaßwiderstand Rₒₙ bei gleichzeitig hoher Spannungsfestigkeit.

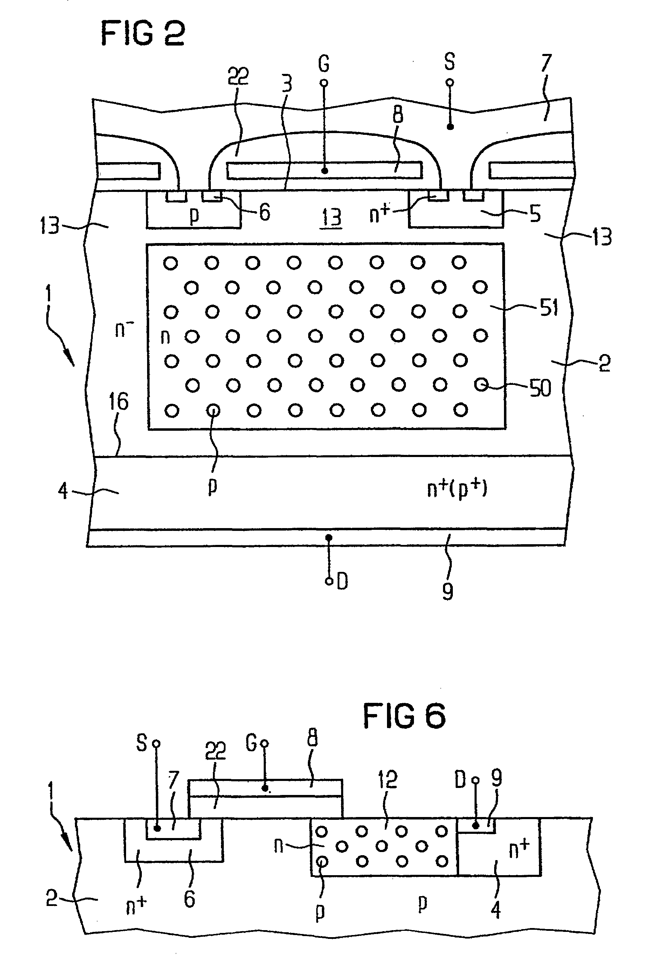

In der Figur 2 ist eine alternative Ausführungsform der vorliegenden Erfindung anhand eines V-MOSFETs gezeigt. Dort ist in eine n⁻-dotierte Innenzone 2 eine sich von den Zwischenzellenzonen 13 unter die Basiszonen 5 erstreckende n-dotierte Komplementärausräumzone 51 eingebracht. Innerhalb dieser Komplementärausräumzone 51 sind eine Vielzahl von p-dotierten Ausräumzonen 50 eingebracht. Die Verteilung dieser Ausräumzonen 50 kann statistisch oder regelmäßig sein. Die Ausräumzonen 50 können dabei eine beliebige Form aufweisen, wobei die in der Figur 2 gezeigten Ausräumzonen 50 eine in etwa kugelförmige Gestalt aufweisen. Auch hier ist die Gesamtmenge der Dotierungen in den verteilten Ausräumzonen 50 in etwa gleich der Gesamtmenge der Dotierungen in der n-dotierten Komplementärausräumzone 51. Ferner ist der Abstand zwischen den Ausräumzonen 50 kleiner als die Breite der Raumladungszone zwischen den Ausräumzonen 50 und der Komplementärausräumzone 51 bei der Durchbruchspannung zwischen den Ausräumzonen 50 und der Komplementärausräumzone 51.

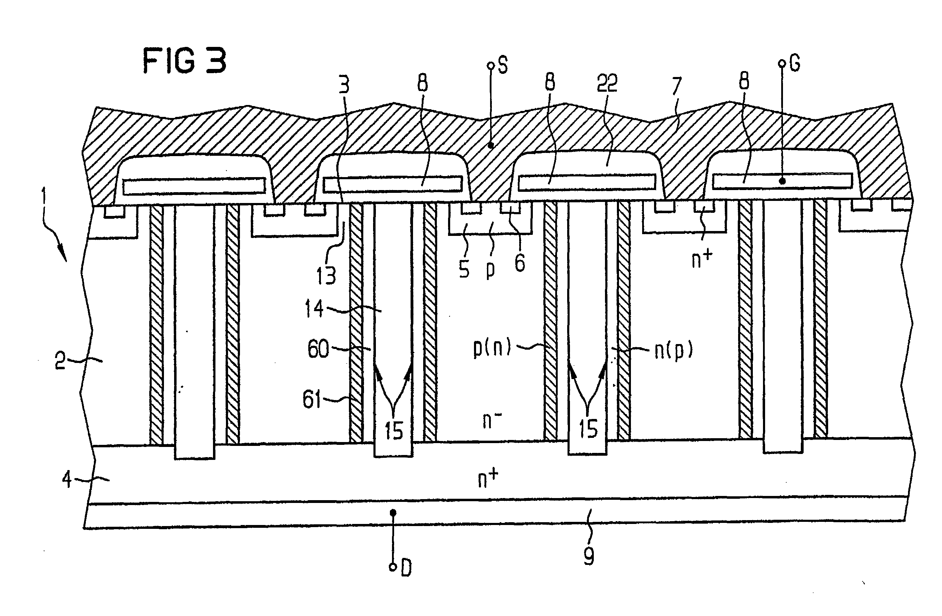

Die Figur 3 zeigt ein weiteres Ausführungsbeispiel, eines erfindungsgemäßen V-MOSFETs. Dieser MOSFET unterscheidet sich von den in den Figuren 1 bzw. 2 gezeigten in der Ausgestaltung der Innenzone 2. Unterhalb der durch Gateoxid 22 isolierten Gateelektroden 8 erstrecken sich hier von der sourceseitigen Oberfläche 3 der Innenzone 2 bis in die Drainzone 4 hinein im Bereich der Zwischenzellenzonen 13 vertikale Gräben 14. Diese Gräben 14 sind teilweise oder vollständig mit isolierendem Material, z.B. Silizumoxid und/oder schwach dotiertem Polysilizium aufgefüllt. Auch eine Kombination von mehreren übereinanderliegenden Isolationsschichten mit dazwischenliegenden schwach dotiertem Polysilizium ist möglich.

Die so mit isolierendem Material aufgefüllten Gräben 14 sind von der Innenzone 2 über eine n-dotierte Komplementärausräumzone 61 getrennt, welche mit einer p-dotierten Ausräumzone 60 versehen ist. Die so von den Ausräumzonen 60 und Komplementärausräumzonen 61 erzeugten Grabenumhüllungen sind in ihrer Dotierung dabei so bemessen, daß bei einer U_{D}-Spannung, welche kleiner als die Durchbruchspannung zwischen den Ausräumzonen 60 und Komplementärausräumzonen 61 ist, die Ausräumzone 60 und die Komplementärausräumzone 61 nahezu vollkommen ausgeräumt werden.

Der Querschnitt der Gräben 14 kann rund, streifenförmig oder beliebig sein. Die Gräben 14 müssen sich dabei nicht bis in die Drainzone 4 erstrecken, vielmehr ist der Tiefenverlauf frei wählbar. Wird z.B. ein runder Grabenquerschnitt gewählt, so erhalten die den mit isolierendem Material aufgefüllten Graben 14 umhüllenden Ausräumzonen 60 und Komplementärausräumzonen 61 eine quasi zylindrische Form.

Die Reihenfolge der Dotierung der Ausräumzonen 60 und Komplementärausräumzonen 61 zwischen der Innenzone 2 und dem Graben 14 ist dabei beliebig, d.h. die Komplementärausräumzone 60 kann sowohl zwischen Graben 14 und Komplementärausräumzone 61 als auch zwischen Komplementärausräumzone 61 und Innenzone 2 angeordnet sein.

Ferner ist es auch möglich, nur einen Teil der Grabenwände 15 mit Ausräumzonen 60 und Komplementärausräumzonen 61 zu belegen.

Die Figur 4 zeigt ein weiteres Ausführungsbeispiel entsprechend der in Figur 3 dargestellten Anordnung. Der Unterschied zur Anordnung gemäß Figur 3 besteht in der Ausgestaltung der Gateelektrode. Im Gegensatz zu der in Figur 3 dargestellten Anordnung ist hier die Gateelektrode zweigeteilt bzw. weist eine Gateaussparung 19 auf, die die Gateelektrode in einen ersten Teilbereich 17 und einen zweiten Teilbereich 18 aufteilt. Sinn dieser Anordnung ist, daß durch eine so ausgebildete Gateelektrode der darunter befindliche Graben 14 maskiert wird. Dadurch kann ein vereinfachtes Herstellverfahren des Grabens 14 erzielt werden. Wie bei bekannten Strukturen, bei denen das Gate zur Maskierung bestimmter Bereiche während des Herstellverfahrens dient, wird hier durch die Form des Gates die Ausbildung des Grabens 14 entsprechend der Formgebung der Gateaussparung 19 eingestellt.

Figur 5 zeigt ein weiteres Ausführungsbeispiel eines vertikalen MOSFETs. Der hier gezeigte V-MOSFET entspricht ebenfalls im wesentlichen der in Figur 3 wiedergegebenen Struktur mit dem Unterschied, daß der Graben 14' hier als annähernd V-förmiger Graben ausgebildet ist. Dementsprechend sind auch die Ausräumnzonen und Komplementärausräumzonen V-förmig ausgebildet. Ebenso ist es jedoch auch denkbar, den Scheitel bzw. Umkehrpunkt des Grabens 14' U-förmig auszubilden. Ein derartiger Trench-V-MOSFET ist leicht herstellbar, wenn die Gräben wie in Figur 5 dargestellt, V-förmig ausgebildet sind, wobei ein sehr kleiner Winkel Φ, vorzugsweise 5° bis 10° verwendet wird. Dann können die Grabenwände 15' durch Ionenimplantation mit einem Einfallswinkel von 0° mit hoher Genauigkeit und Gleichmäßigkeit belegt werden. Die unterschiedlichen Dotierungen der Ausräumzonen und Komplementärausräumzonen können aus der Grabenwand durch eine oder mehrere Hochtemperaturbehandlungen in das einkristalline Silizium der Drainzone 4 und der Innenzone 2 eingetrieben werden. Es ist hier auch denkbar, daß jeweils nur eine Grabenseitenwand mit einer Ausräumzone bzw. einer Komplementärausräumzone belegt wird.

Figur 6 zeigt ein weiteres Ausführungsbeispiel, welches einen lateralen MOSFET darstellt. Wie aus der Figur 6 ersichtlich ist, besteht der laterale MOSFET aus einem Halbleiterkörper 1 mit einer p-dotierten Innenzone 2. In die p-dotierte Innenzone 2 ist auf deren Oberfläche 3 eine n-dotierte Sourcezone 6 eingebracht. In der n-dotierten Sourcezone 6 befindet sich eine Sourceelektrode 7 aus Metallsilizid, welche mit einem Sourceanschluß S verbunden ist. Ferner ist eine ebenfalls n-dotierte Drainzone 4 in die Oberfläche 3 des Halbleiterkörpers 1 eingebracht. Die n-dotierte Drainzone 4 weist wiederum eine Drainelektrode 9 aus Metallsilizid auf, die einen Drainanschluß D aufweist. Zwischen Sourcezone 6 und Drainzone 4 befindet sich eine Driftzone 12, die schwach n-dotiert ist. In diese Driftzone 12 sind wiederum Ausräumzonen 10 eingebracht, die p-dotiert sind. Der Abstand der einzelnen p-dotierten Ausräumzonen 10 zueinander ist vorzugsweise wiederum kleiner als die Breite der Raumladungszone zwischen der eingebrachten p-dotierten Ausräumzonen 10 und der schwach n-dotierten Driftzone 12. Auch hier ist die Gesamtmenge der Dotierungen in den verteilten p-dotierten Ausräumzonen 10 in etwa-gleich mit der Gesamtmenge der Dotierungen in derschwach n-dotierten Driftzone 12.

Über dem Halbleiterkörper befindet sich in bekannter Weise eine Gateelektrode 8, die gegenüber dem gesamten Halbleiterkörper 1 über ein Gateoxid 22 isoliert ist. Die Gateelektrode 8 kann auch in bekannter Weise so ausgestaltet werden, daß der Abstand zwischen der Gateelektrode 8 und der p-dotierten Innenzone 2 von der Sourcezone 6 in Richtung der Drainzone 4 zunimmt.

Die Funktionsweise einer derartigen lateralen erfindungsgemäßen Struktur wird im folgenden näher erläutert. Bei kleiner Drainspannung ist die Leitfähigkeit gut, da die n-dotierte Driftzone 12 niederohmig ist. Wird die Drainspannung moderat erhöht, so räumen sich die Ausräumzonen 10 und die Driftzone 12 gegenseitig aus. Bei einer weiteren Spannungserhöhung wird nun die laterale Feldstärke derart erhöht, daß das ganze Volumen der Driftzone 12 ausgeräumt wird. Der zwischen der Driftzone 12 und der Sourcezone 6 liegende Bereich der Innenzone 2 nimmt dann die weitere Spannung auf.

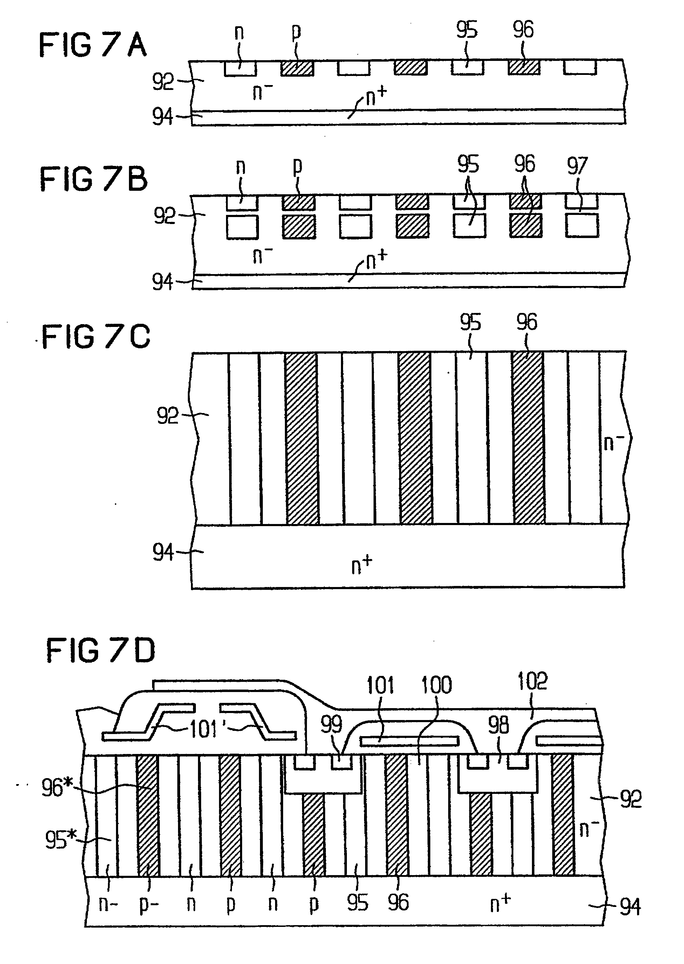

Die Figuren 7a bis 7d zeigen ein mögliches Herstellverfahren für ein vertikales Halbleiterbauelement gemäß der vorliegenden Erfindung. Auf einem n⁺-dotierten Substrat 94 wird eine erste dünne n⁻-dotierte Schicht 92 epitaktisch aufgewachsen. Diese wird beispielsweise durch entsprechende Maskierung und Ionenimplantation mit sich abwechselnden n-dotierten bzw. p-dotierten Bereichen 95, 96 dotiert. Die Dotierung kann selbstverständlich auch durch andere bekannte Verfahren erfolgen.

Danach wird, wie in Figur 7b zu sehen ist, eine weitere n⁻-dotierte Schicht 97 epitaktisch aufgebracht. Durch Wiederholen dieses Schrittes wird durch eine mehrstufige Epitaxieabscheidung schließlich die n⁻-dotierte Zone 92 bis zu den noch einzubringenden Basiszonen 98 vervollständigt.

Je nach verwendeten Masken können pro Schicht die unterschiedlichsten Strukturen gebildet werden. Die Dotierungen der Ausräumzonen 95 und Komplementärausräumzonen 96 können z.B. derart gewählt-werden, daß sich die eihzelnen Ausräumzonen 95 und Komplementärausräumzonen 96 einer Schicht nach einer Hochtemperaturbehandlung mit denjenigen der darunterliegenden Schicht verbinden, so daß-sich insgesamt, wie in Figur 7c dargestellt, streifenförmige Ausräumzonen 95 und streifenförmige Komplementärausräumzonen 96 ausbilden. Die in den einzelnen Schichten dotierten Ausräumzonen 95 und Komplementärausräumzonen 96 können jedoch auch voneinander getrennt sein, wie es in den Bereichen A und C in den in der Figur 1 dargestellt ist. Durch entsprechende Wahl der Masken können auch statistische räumliche Verteilungen der einzelnen Gebiete erreicht werden.

Schließlich werden die Basiszonen 98 und die Sourcezonen 99 eine weitere aufgebrachte Epitaxieschicht eingebracht und in den übrigen Bereiche kann z.B. eine weitere Dotierung von Ausräumzonen und Komplementärausräumzonen erfolgen, so daß sich die streifenförmigen Ausräumzonen- 95 und Komplementärausräumzonen 96 in den Zwischenzellenzonen 100 bis zur Oberfläche erstrecken.

Die am Randbereich eingebrachten Ausräumzonen und Komplementärausräumzonen in Figur 7d sind mit 95' und 96' bezeichnet. Diese am Rand liegenden Ausräumzonen 95' und Komplementärausräumzonen 96' werden vorzugsweise schwächer als die im Inneren des Halbleiterkörpers liegenden übrigen Ausräumzonen 95 und Komplementärausräumzonen 96 dotiert. Es folgen nun weitere Schritte zur Aufbringung der Gateelektrode 101 bzw. der Randgateelektrode 101' und der Sourceelektrode 102 in bekannter Weise.

In den Figuren 8a bis 8c-wird ein weiteres verbessertes Verfahren zur Herstellung eines vertikalen durch Feldeffekt steuerbaren Halbleiterbauelements gemäß der vorliegenden Erfindung gezeigt. Dort geschieht das Einbringen der Ausräumzonen 95' und Komplementärausräumzonen 96' über den Umweg einer ersten speziellen epitaktisch abgeschiedenen Schicht. Auf einem Substrat 94' wird eine erste Epitaxieschicht 92' aufgebracht, die gleichzeitig p-Dotierstoffe und n-Dotierstoffe in etwa gleichen Mengen enthält. Dabei sind die Dotierstoffe so gewählt werden, daß die Diffusionskoeffizienten der beiden Dotierelemente sich deutlich voneinander unterscheiden. Besonders geeignet sind als p-Dotierstoff Bor und als n-Dotierstoff Arsen, da der Diffusionskoeffizient von Arsen etwa 10 mal größer ist als der von Bor.

Danach werden Gräben 93' in den gewünschten geometrischen Ausmaßen in diese erste Epitaxieschicht 92' geätzt, wobei es auf eine extrem gute Reproduzierbarkeit bei diesem Schritt nicht ankommt.

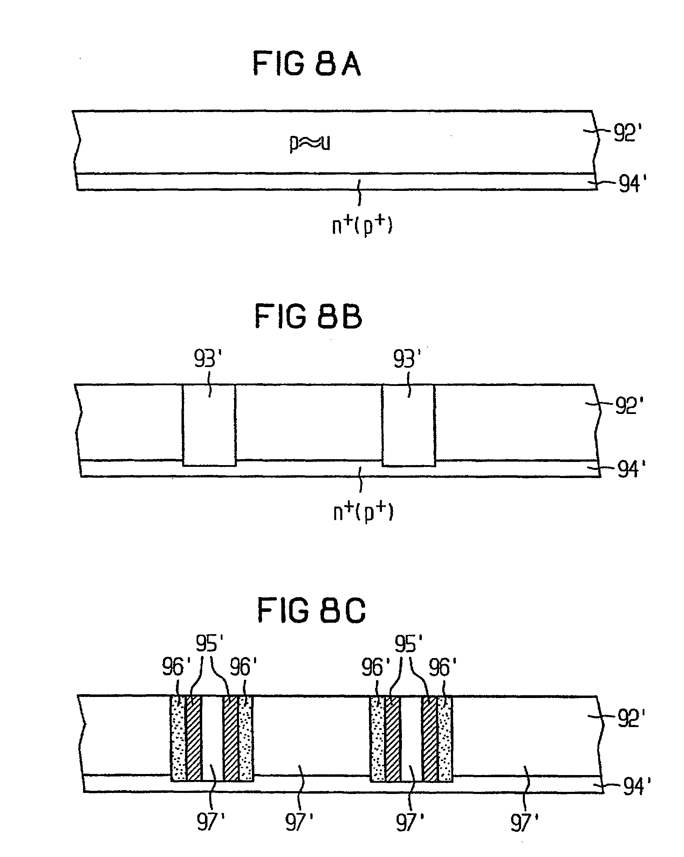

Danach werden die Gräben 93' mit einer zweiten hochohmigen Epitaxieschicht 97' aufgefüllt, wobei diese zweite Epitaxieschicht 97' den Graben in der Weise ausfüllt, daß keinerlei Kristallstörungen auftreten. Dies ist in Figur 8b veranschaulicht.

Schließlich wird der so prozessierte Halbleiterkörper danach einem Temperaturschritt unterworfen, bei dem die beiden unterschiedlich schnell diffundierenden Elemente der ersten Epitaxieschicht 92', z.B. also die Dotierstoffe Arsen und Bor, in die zweite Epitaxieschicht 97' eindiffundieren können. Aufgrund des unterschiedlichen Diffusionskoeffizienten reichert sich der besser diffundierende Dotierstoff, im vorliegenden Beispiel Bor, in der zweiten Epitaxieschicht 97' an, während der schlechter diffundierende Dotierstoff, im vorliegenden Beispiel Arsen, in der ersten Epitaxieschicht 92' am Rand zum Graben überwiegt.

Nach diesem Temperschritt, der auch mit den nachfolgenden Schritten des Herstellungsprozesses für das zu fertigende Halbleiterbauelement kombiniert werden kann, ist am Rande des Grabens jeweils eine Ausräumschicht 95' und eine Komplementärausräumschicht 96' vorhanden. Die Gesamtmenge von p-Dotierung bzw. n-Dotierung ist somit immer etwa gleich groß, da die ursprünglich eingebrachte Dotierung durch den beschriebenen Prozeß nun anders verteilt wird. Der Prozeß ist demnach quasi selbstjustierend.

Die Einbringung der Basiszonen, Sourcezonen, sowie die Aufbringung der Gateelektrode und die Ausbildung der Randbereiche erfolgt analog zu dem Verfahren, das oben beschrieben wurde.

Die in den Figuren 7 und 8 gezeigten Verfahren lassen sich leicht zur Herstellung von lateralen MOSFETs modifizieren.

Zusammenfassend läßt sich sagen, daß durch die vorliegende Erfindung sowohl vertikale wie auch laterale MOSFETs sowie IGBTs mit niedrigem Durchlaßwiderstand Rₒₙ bei gleichzeitig hoher Sperrspannung vorgesehen werden können. Wesentlich ist die Ausbildung von paarweisen p- bzw. n-dotierten Bereichen, welche strukturiert oder statistisch eingebracht sind, wobei vorzugsweise streifenförmige Bereiche vorgesehen sind, die entlang des Strompfades der Laststrecke ausgebildet sind. Die vorliegende Erfindung ist dabei sowohl bei MOSFETs vom p-Kanal wie auch bei MOSFETs vom n-Kanal oder auch entsprechenden IGBTs anwendbar.

### Bezugszeichenliste

- 1 =: Halbleiterkörper
- 2 =: Innenzone
- 3 =: sourceseitige Oberfläche
- 4 =: Drainzone
- 5 =: Basiszone
- 6 =: Sourcezone
- 7 =: Sourceelektrode
- 8 =: Gateelektrode
- 9 =: Drainelektrode
- 10 =: Ausräumzone
- 11 =: Komplementärausräumzone
- 12 =: Driftzone
- 13 =: Zwischenzellenzone
- 14 =: Graben
- 15 =: Grabenwand
- 16 =: drainseitige Oberfläche
- 17 =: Gateaussparung
- 18 =: erster Gatebereich
- 19 =: zweiter Gatebereich
- 20,30,40,50,60,70 =: Ausräumzone
- 21,31,41,51,61,71 =: Komplementärausräumzone
- 22 =: Gateoxid
- 92 =: erste n⁻-Epitaxieschicht
- 92' =: erste Epitaxieschicht
- 93' =: Graben
- 94 =: n⁺-Substrat
- 94' =: Substrat
- 95 =: p-dotierter Bereich = Ausräumzone
- 95' =: Ausräumschicht
- 95* =: Randausräumzone
- 96 =: n-dotierter Bereich = Komplementärausräumzone
- 96' =: Komplementärausräumschicht
- 96* =: Randkompanz
- 97 =: zweite n⁻-Epitaxieschicht
- 97' =: zweite Epitaxieschicht
- 98 =: Basiszone
- 99 =: Sourcezone
- 100 =: Zwischenzellenzone
- 101 =: Gateelektrode
- 101' =: Randgateelektrode
- 102 =: Sourceelektrode

## Patentansprüche

1. Durch Feldeffekt steuerbares Halbleiterbauelement bestehend aus einem Halbleiterkörper (1)
I. mit einer Innenzone (2) vom ersten Leitungstyp, die an eine Oberfläche (3) des Halbleiterkörpers (1) angrenzt,
II. mit einer Drainzone (4), die an die Innenseite (2) angrenzt,
III. mit mindestens einer Basiszone (5) vom zweiten Leitungstyp, die an der Oberfläche (3) in den Halbleiterkörper (1) eingebettet ist,
IV. mit mindestens einer Sourcezone (6) vom ersten Leitungstyp, welche jeweils in die Basiszone (5) eingebettet ist,
V. mit mindestens einer Sourceelektrode (7) die jeweils mindestens eine Basiszone (5) und die darin eingebettete Sourcezone (6) kontaktiert,
VI. mit mindestens einer, gegen den gesamten Halbleiterkörper (1) und gegen die Sourceelektrode (7) isolierten Gateelektrode (8),
VII. mit mindestens einer Ausräumzone (10, 20, 30, 40, 50, 60, 70, 95, 95', 95*) vom zweiten Leitungstyp,
VIII.mit mindestens einer Komplementärausräumzone (11, 21, 31, 41, 51, 61, 71, 96, 96', 96*) vom ersten Leitungstyp,
IX. wobei jeweils in einer einzelnen Komplementärausräumzone (12, 51) eine Vielzahl von Ausräumzonen (10, 50) vorgesehen sind,
X. wobei die Gesamtmenge der Dotierung in der einzelnen Komplementärausräumzone (12, 51) in etwa der Gesamtmenge der Dotierung der darin enthaltenen Ausräumzonen (10, 50) entspricht,
**dadurch gekennzeichnet, dass**
XI. die Ausräumzonen (10, 50) floatend in der Komplementärausräumzone (12, 51) angeordnet sind.

2. Halbleiterbauelement nach Anspruch 1,
**dadurch gekennzeichnet,**
**dass** die einzelne Komplementärausräumzone (12, 51) mit der Innenzone (2) identisch ist.

3. Halbleiterbauelement nach einem der vorstehenden Ansprüche,
**dadurch gekennzeichnet,**
**dass** die Ausräumzonen (10, 50) streifenförmig ausgebildet sind.

4. Halbleiterbauelement nach einem der vorstehenden Ansprüche,
**dadurch gekennzeichnet,**
**dass** die Ausräumzonen (10, 50) fadenförmig ausgebildet sind.

5. Halbleiterbauelement nach einem der vorstehenden Ansprüche,
**dadurch gekennzeichnet,**
**dass** die Ausräumzonen (10, 50) in etwa kugelförmig ausgebildet sind.

6. Halbleiterbauelement nach einem der vorstehenden Ansprüche,
**dadurch gekennzeichnet,**
**dass** der Abstand der Ausräumzonen (10, 50) voneinander kleiner oder gleich der Breite der Raumladungszone zwischen Ausräumzonen (10, 50) und der Komplementärausräumzone (12, 51) ist.

7. Halbleiterbauelement nach einem der vorstehenden Ansprüche,
**dadurch gekennzeichnet,**
**dass** das Halbleiterbauelement als laterales Halbleiterbauelement ausgebildet ist, bei dem die Komplementärausräumzone (12, 51) und damit auch die darin enthaltenen Ausräumzonen (10, 50) in einer Driftzone (12) vom zweiten Leitungstyp angeordnet sind, wobei die Driftzone (12) zwischen der Sourcezone (6) und der Drainzone (4) angeordnet ist und an die Drainzone (4) angrenzt.

## Claims

1. Field effect-controllable semiconductor component comprising a semiconductor body (1)
I. having an inner zone (2) of the first conduction type, which adjoins a surface (3) of the semiconductor body (1),
II. having a drain zone (4), which adjoins the inner side (2),
III. having at least one base zone (5) of the second conduction type, which is embedded on the surface (3) in the semiconductor body (1),
IV. having at least one source zone (6) of the first conduction type, which in each case is embedded in the base zone (5),
V. having at least one source electrode (7), which in each case makes contact with at least one base zone (5) and the source zone (6) embedded therein,
VI. having at least one gate electrode (8), which is insulated from the entire semiconductor body (1) and from the source electrode (7),
VII. having at least one depletion zone (10, 20, 30, 40, 50, 60, 70, 95, 95', 95*) of the second conduction type,
VIII. having at least one complementary depletion zone (11, 21, 31, 41, 51, 61, 71, 96, 96', 96*) of the first conduction type,
IX. with a multiplicity of depletion zones (10, 50) being provided in each individual complementary depletion zone (12, 51),
X. with the total amount of doping in the single complementary depletion zone (12, 51) corresponding approximately to the total amount of doping in the depletion zones (10, 50) contained therein,
**characterized in that**
XI. the depletion zones (10, 50) are arranged in a floating manner in the complementary depletion zone (12, 51).

2. Semiconductor component according to Claim 1,
**characterized in that** the single complementary depletion zone (12, 51) is identical to the inner zone (2).

3. Semiconductor component according to any of the preceding claims,
**characterized in that** the depletion zones (10, 50) are designed such that they are in the form of a strip.

4. Semiconductor component according to any of the preceding claims,
**characterized in that** the depletion zones (10, 50) are designed such that they are in the form of a thread.

5. Semiconductor component according to any of the preceding claims,
**characterized in that** the depletion zones (10, 50) are designed such that they are approximately spherical.

6. Semiconductor component according to any of the preceding claims,
**characterized in that** the distance between the depletion zones (10, 50) is less than or equal to the width of the space charge zone between depletion zones (10, 50) and the complementary depletion zones (12, 51).

7. Semiconductor component according to one of the preceding claims,
**characterized in that** the semiconductor component is a lateral semiconductor component in which the complementary depletion zones (12, 51) and thereby also the depletion zones (10, 50) contained therein are arranged in a drift zone (12) of the second conduction type, the drift zone (12) being arranged between the source zone (6) and the drain zone (4) and adjoining the drain zone (4).

## Revendications

1. Composant à semi-conducteur qui peut être commandé par effet de champ et est constitué d'un corps à semi-conducteur (1)
I. comportant une zone intérieure (2) du premier type de conduction laquelle avoisine une surface (3) d'un corps à semi-conducteur (1),
II. comportant une zone de drain (4) qui avoisine le côté intérieur (2),
III. comportant au moins une zone de base (5) du deuxième type de conduction laquelle est encastrée dans le corps à semi-conducteur (1) à la surface (3),
IV. comportant au moins une zone de source (6) du premier type de conduction laquelle est à chaque fois encastrée dans la zone de base (5),
V. comportant au moins une électrode source (7) qui est à chaque fois en contact avec une zone de base (5) et la zone de source (6) qui y est encastrée,
VI. comportant au moins une électrode grille (8) isolée de tout le corps à semi-conducteur (1) et de l'électrode source (7),
VII. comportant au moins une zone évidée (10, 20, 30, 40, 50, 60, 70, 95, 95', 95*) du deuxième type de conduction,
VIII. comportant au moins une zone évidée complémentaire (11, 21, 31, 41, 51, 61, 71, 96, 96', 96*) du premier type de conduction,
IX. un grand nombre de zones évidées (10, 50) étant à chaque fois prévues dans une zone évidée complémentaire (12, 51) particulière,
X. la quantité totale du dopage dans la zone évidée complémentaire (12, 51) particulière correspondant approximativement à la quantité totale du dopage dans les zones évidées (10, 50) qui y sont contenues,
**caractérisé en ce que**
XI. les zones évidées (10, 50) sont disposées de façon flottante dans la zone évidée complémentaire (12, 51).

2. Composant à semi-conducteur selon la revendication 1,
**caractérisé en ce que**
la zone évidée complémentaire (12, 51) particulière est identique à la zone intérieure (2).

3. Composant à semi-conducteur selon l'une des revendications précédentes,
**caractérisé en ce que**
les zones évidées (10, 50) se présentent sous forme de bandes.

4. Composant à semi-conducteur selon l'une des revendications précédentes,
**caractérisé en ce que**
les zones évidées (10, 50) se présentent sous forme de fils.

5. Composant à semi-conducteur selon l'une des revendications précédentes,
**caractérisé en ce que**
les zones évidées (10, 50) se présentent approximativement sous forme sphérique.

6. Composant à semi-conducteur selon l'une des revendications précédentes,
**caractérisé en ce que**
l'écart des zones évidées (10, 50) les unes par rapport aux autres est plus petit ou égal à la largeur de la zone de charge spatiale entre les zones évidées (10, 50) et la zone évidée complémentaire (12, 51).

7. Composant à semi-conducteur selon l'une des revendications précédentes,
**caractérisé en ce que**
le composant à semi-conducteur est formé en tant que composant à semi-conducteur latéral, pour lequel la zone évidée complémentaire (12, 51) et donc aussi les zones évidées (10, 50) qui y sont contenues sont disposées dans une zone de dérive (12) du deuxième type de conduction, la zone de dérive (12) étant disposée entre la zone de source (6) et la zone de drain (4) et avoisinant la zone de drain (4).
